# EUROPEAN PATENT SPECIFICATION

(11) **EP 2 517 269 B1**
(45) Date of publication and mention of the grant of the patent: **09.03.2016**
(21) Application number: 10805436.2
(22) Date of filing: 22.12.2010
(51) Int. Cl.: H01L 31/18, H01L 31/072, H01L 31/0296

(54) **A thin-film photovoltaic cell and its method of manufacturing**
Photovoltaische Dünnschichtzelle und deren Herstellungsverfahren
Cellule photovoltaïque à couches minces et son procédé de fabrication

(30) Priority: 22.12.2009 FI 20096380
(43) Date of publication of application: 31.10.2012
(73) Proprietor: Beneq Oy, 01510 Vantaa (FI)
(72) Inventor: SKARP, Jarmo, FI-02750 Espoo (FI)
(74) Representative: Papula Oy
(86) International application number: PCT/FI2010/051072
(87) International publication number: WO 2011/077008

(56) References cited:
- JOHNSTON D A ET AL: "Chemical bath deposition of zinc sulfide based buffer layers using low toxicity materials", THIN SOLID FILMS ELSEVIER SWITZERLAND, vol. 403-404, 1 February 2002 (2002-02-01) , pages 102-106, XP002659724, ISSN: 0040-6090, DOI: 10.1016/s0040-6090(01)01536-x
- PLATZER-BJÖRKMAN C ET AL: "Zn(O,S) buffer layers by atomic layer deposition in Cu(In,Ga)Se2 based thin film solar cells: Band alignment and sulfur gradient", JOURNAL OF APPLIED PHYSICS, AMERICAN INSTITUTE OF PHYSICS. NEW YORK, US, vol. 100, no. 4, 23 August 2006 (2006-08-23), pages 44506-044506, XP012089821, ISSN: 0021-8979 cited in the application
- PERRENOUD J ET AL: "Application of ZnO1â xSx as window layer in cadmium telluride solar cells", 35TH IEEE PHOTOVOLTAIC SPECIALISTS CONFERENCE (PVSC), 20-25 JUNE 2010, HONOLULU, HI, USA, IEEE, PISCATAWAY, NJ, USA, 20 June 2010 (2010-06-20), pages 995-1000, XP031784309, ISBN: 978-1-4244-5890-5
- VENKATA SUBBAIAH Y P ET AL: "Growth and characterization of ZnSxSe1-x films deposited by close-spaced evaporation; Growth and characterization of ZnSxSe1-x films", JOURNAL OF PHYSICS D. APPLIED PHYSICS, IOP PUBLISHING, BRISTOL, GB, vol. 40, no. 12, 21 June 2007 (2007-06-21) , pages 3683-3688, XP020111613, ISSN: 0022-3727, DOI: 10.1088/0022-3727/40/12/021
- RAMASUBRAMANIAN S ET AL: "Theoretical investigation of the electronic and optical properties of Zn2OX (X=S, Se, Te) in chalcopyrite phase by full potential methods", JOURNAL OF ALLOYS AND COMPOUNDS, ELSEVIER SEQUOIA, LAUSANNE, CH, vol. 479, no. 1-2, 24 June 2009 (2009-06-24), pages 414-419, XP026108847, ISSN: 0925-8388, DOI: 10.1016/J.JALLCOM.2008.12.118 [retrieved on 2009-01-04]
- THANGAVEL R ET AL: "First-principle calculations of structural stability of II-O1-xVIx (II-Zn, Cd and VI-S, Se, Te) ordered chalcopyrite semiconductors", PHYSICA B. CONDENSED MATTER, AMSTERDAM, NL, vol. 403, no. 10-11, 1 May 2008 (2008-05-01), pages 1824-1830, XP022711800, ISSN: 0921-4526, DOI: 10.1016/J.PHYSB.2007.10.013 [retrieved on 2007-10-17]

## Description

### FIELD OF THE INVENTION

The present invention relates, in general, to photovoltaic cells. It is directed at the semiconductor layer structure forming the key operational portion of a photovoltaic cell. In more detail, the present invention is focused on Cadmium Telluride (CdTe) based photovoltaic cells, particularly on the n-type semi-conductor layers, i.e. the so called window layers of such cells.

### BACKGROUND OF THE INVENTION

Photovoltaic cells are used in a great variety of applications to convert electromagnetic radiation to electrical energy. One particular field within the photovoltaic cell industry and business is the field of solar cells utilizing sunlight as the primary energy source.

By photovoltaic cell is meant here generally a semiconductor-based component converting incident electromagnetic radiation to electrical energy through a photovoltaic effect. The simplified basic structure of a photovoltaic cell of the type discussed here typically comprises a window layer of a first conductivity type semiconductor material and an absorbing layer of a second conductivity type semiconductor material. At the interface between these two different type semiconductor layers is a pn-junction. The photons of the incident light, having energy below the band gap energy of the window layer material, penetrate through the window layer to the absorbing layer. In the absorbing layer, photons with energy equal to or greater than the band gap energy of the absorbing layer material are absorbed, thus exciting electrons from the valence band to the conduction band. The free charge carriers generated this way are then collected by means of electrodes connected to the different sides of the pn-junction.

One promising technological trend within the photovoltaic cell development is the field of thin film cells. In thin film photovoltaic cells the semiconductor layers of the device are realized as thin layers with a thickness in a range from a few nanometers to some tens of micrometers.

The thin film photovoltaic cells as well as the photovoltaic cells in general are usually categorized according to the absorbing layer material. The most widely used thin film absorbing layer materials are amorphous Silicon a-Si, Cadmium Telluride CdTe, and Copper Indium Gallium Selenide CIGS. Each of those materials determines one discrete cell type and thus forms a discrete field of technology with characteristic features thereof differing from the fields of the other cell types. The differences between those different technologies lie not only in the actual absorbing layer material and the other materials and the detailed operation of the cell but also in the manufacturing processes and production facilities required and being most suitable to produce the photovoltaic cells. This means that a production plant configured to produce cells of one type is not straightforwardly transformable for manufacturing of some other cell type. This typically compels the thin film photovoltaic cell manufacturers to select one of those technologies only.

Among the mentioned cell types, CdTe cells are nowadays often seen as the leading technology. This is based on an overall consideration focusing not only to the device performance (it is known that e.g. CIGS thin film cells can provide higher efficiency than CdTe-based ones) but taking into account also the manufacturing points of view related to e.g. the manufacturing costs.

In CdTe thin film cells, the n-type window material is cadmium sulfide CdS, which according to the established understanding in the field actually is the only suitable n-type material for CdTe cells. These two materials form a good pn-junction and they are also compatible with each other from the manufacturing point of view. CdTe/CdS cells have been under intensive development for a long time, the most intensive development in the recent years having been focused on optimizing the doping of the CdTe and the back electrode structure and on manufacturing. As a result, the state of the art CdTe/CdS cells nowadays reach about half of the maximum theoretical efficiency of 30 %.

There is, however, one well known problem associated with CdS. The bandgap energy of CdS is 2,4 eV which corresponds to a wavelength of about 520 nm. Thus, wavelengths below this value are absorbed in the window layer and thus do not contribute to the current generated by the photovoltaic cell. This is a significant problem e.g. in solar cells converting the solar radiation into electrical energy.

One known approach to lighten the problem described above is using a lower CdS layer thickness. The lower the thickness is the higher portion of the radiation of wavelengths below said limit value can pass through the CdS layer. However, another problem arising along with the CdS layer thinning is the possible pinhole formation creating localized junctions between CdTe and the upper transparent conductive oxide TCO current collecting layer usually present above CdS. These kinds of points of direct contact between CdTe and TCO would deteriorate drastically the device performance.

A thin-film photovoltaic cell comprising a CdTe absorption layer and a ZnS window layer is discussed in Johnston D. A. et al: "Chemical bath deposition of zinc sulfide based buffer layers using low toxicity materials", THIN SOLID FILMS ELSEVIER SWITZERLAND, val. 403-404, 1 February 2002 (2002-02-01), pages 102-106, XP002659724, ISSN: 0040-6090, DOl: 10.1 016/s0040-6090 (01) 01536-x.

### PURPOSE OF THE INVENTION

The purpose of the present invention is to provide a novel highly efficient photovoltaic cell structure.

### SUMMMARY OF THE INVENTION

The present invention is characterized by what is presented in claims 1, 3, and 5.

A thin film photovoltaic cell according to one aspect of the present invention comprises an n-type semiconductor window layer, a p-type semiconductor absorption layer, and a pn-junction at the interface between these two layers, wherein the p-type semiconductor absorption layer is formed of cadmium telluride CdTe.

By "thin film photovoltaic cell" is meant here a photovoltaic cell structure where the key operational parts of the device, like the window layer and the absorption layer, are realized as a stack of thin, substantially planar films having thicknesses in a range from a few nanometers to some tens of micrometers. "Window layer" means the layer at the side of the incident radiation, through which the incident radiation with photons having energy below the bandgap energy of the window layer material propagates to the absorption layer. In the absorption layer formed of CdTe having a narrower bandgap, the photons with an energy equal to or exceeding the bandgap energy of CdTe are absorbed by transferring their energy to the electrons of CdTe, thus creating in the structure free charge carriers as electron-hole pairs.

Naturally, a CdTe thin film photovoltaic cell, i.e. a cell with CdTe as the absorbing layer material, as a complete device, contains also other parts than said window and absorption layers in the core of the device. The entire device is formed on a growth substrate which typically is made of glass. The layer next to the substrate is usually a transparent conductive oxide TCO layer for ensuring efficient collection of the generated current over the entire device area. The window layer is in contact with the TCO layer. Below the absorption layer is a layer of a conductive material, e.g. some metal, forming the back electrode of the device to provide an electrical connection to the absorption layer. In addition, the complete device can also comprise other layers for different purposes as needed. However, such possible layers (e.g. for the back electrode contact) are not essential from the point of view of the main principle of the present invention.

According to the present invention, the n-type semiconductor window layer comprises zinc oxide/sulfide Zn(O,S). Thus, in contrast to all prior art approaches based on the basic structure of CdTe/CdS and optimizing the details therein, the present invention takes a drastic step in introducing an entirely novel window layer material for CdTe cells.

Zn(O,S) is a zinc oxide ZnO based material. Zn(O,S) comprises stacked thin layer packages, each of which including one sublayer of ZnO and another of ZnS. The thickness of each ZnO sublayer is 1 - 20 monolayers, typically 7 - 12 monolayers, whereas the ZnS sublayer thickness lies within 1 - 10 monolayers, typically 1 - 2 monolayers.

It has now been surprisingly found by the inventor that the physical and chemical properties of Zn(O,S) make it compatible with CdTe, thus enabling a good pn-junction between CdTe and Zn(O,S). Besides, what is essential is that Zn(O,S) has a bandgap wider than that of CdS providing thus, particularly for solar cells, improved efficiency in comparison with CdS. The bandgap of thin film Zn(O,S) is typically 2.7 - 3.6 eV, depending nonlinearly on the O/S) ratio. Thus, the present invention provides a significant enhancement in the CdTe photovoltaic cell device efficiency by shifting the lower end cut-off wavelength clearly below said 520 nm limit of CdS. As another advantage, the present invention decreases the amount of the toxic cadmium in the device.

Besides replacing entirely the CdS in the window layer, the basic principle of the present invention, i.e. a window layer "comprising" Zn(O,S), can be also realized in an embodiment where the window layer comprises a thin sub-layer of CdS attached to the CdTe absorption layer and a thicker sub-layer of Zn(O,S). In this embodiment, the thin layer of CdS forms with CdTe the actual interface between the p-type absorption layer and the n-type window layer. However, also in this embodiment a clear majority of the n-type window layer thickness is formed of Zn(O,S), the transparency of the window layer being thus mainly determined by this material.

The thickness of a window layer according to the present invention can vary depending on the actual window layer composition selected and the desired device performance. A suitable thickness range is 10 - 200 nm, preferably 20 - 50 nm. One aspect to be taken into account in selecting the optimal thickness is the step of re-crystallization of CdTe usually performed at the end of the CdTe cell manufacturing process. This step possibly affects also the structure of the window layer material and can set requirements for the window layer thickness.

Preferably, said n-type semiconductor window layer material is deposited by atomic layer deposition ALD. ALD is a thin film technology enabling accurate and well controlled production of thin film coatings with nanometer-scaled thicknesses. ALD is sometimes called also Atomic Layer Epitaxy ALE. In an ALD process, the substrate is alternately exposed to at least two precursors, one precursor at a time, to form on the substrate a coating by alternately repeating essentially self-limiting surface reactions between the surface of the substrate (on the later stages, naturally, the surface of the already formed coating layer on the substrate) and the precursors. As a result, the deposited material is "grown" on the substrate molecule layer by molecule layer.

In general, coating layers deposited by ALD have several advantageous features. For example, the molecule layer by molecule layer type coating formation means a very accurately controllable layer thickness. On the other hand, due to the surface controlled reactions in the deposition process, the coating is deposited uniformly through the entire surface of the substrate regardless of the substrate geometry. In a CdTe cell according to the present invention, these features mean that the window layer has a very uniform thickness and it covers the underlying device layers with good conformity.

According to a method aspect, the present invention is a method for manufacturing a thin film photovoltaic cell comprising the steps of forming an n-type semiconductor window layer and a p-type semiconductor absorption layer so as to form a pn-junction at the interface between these two layers, wherein the p-type semiconductor absorption layer is formed of cadmium telluride CdTe. The determination above does not fix the manufacturing order of those two layers. However, in the standard CdTe cell processes the order is as presented, i.e. the CdS window layer is formed first. The CdTe absorption layer can be formed by means of an evaporation, a sputtering, or a close spaced sublimation (CSS) process. The initially achieved film is then heat treated with the presence of CdCl₂, leading to re-crystallization of the CdTe and growth of the crystals therein. The process details can be selected according to the well established principles known in the field and are not critical for the basic principle of the present invention.

According to the present invention, the n-type semiconductor window layer is formed so as to comprise zinc oxide/sulfide Zn(O,S). As described above, this material opens great new advantages for the CdTe thin film photovoltaic cells.

The n-type semiconductor window layer material according to the present invention can be formed e.g. by a chemical bath deposition (CBD) method known for deposition of different kinds of thin films. In one preferred embodiment, however, it is deposited by atomic layer deposition ALD. In addition to the advantages in the properties of the deposited film itself, ALD also provides many benefits for the manufacturing process. For example, ALD is a dry (vacuum) process and thus the deposition process can be straightforwardly integrated with the CdTe process (also performed in vacuum). An inline ALD process chamber can be embedded in CdTe processing line in its heating-up section. Also the process costs remain reasonable when solution treatments and cleansing with DI water are not needed. ALD is also a very accurately controllable process. For example, ALD enables making the O/S ratio different on different surfaces of the deposited film. The accurate process details can be chosen according to the principles known within the ALD technology. For example, the deposition temperature for Zn(O,S) can be in the range of 100 - 270°C, preferably 200 - 270°C. Detailed examples of suitable process parameters for Zn(O,S) are presented e.g. in: Platzer-Björkman et al, "Zn(O,S)/Cu(In,Ga)Se2 solar cells: band alignment and sulfur gradient", Journal of Applied Physics 100, 044506 (2006).

According to yet another aspect, the present invention is a novel use of zinc oxide/sulfide Zn(O,S) in the window layer of a thin film photovoltaic cell comprising an n-type semiconductor window layer, a p-type semiconductor absorption layer, and a pn-junction at the interface of these two layers, wherein the p-type semiconductor absorption layer is formed of cadmium telluride CdTe.

Preferably, said n-type semiconductor window layer material is deposited by atomic layer deposition ALD. However, other deposition processes are also possible.

Said use and its preferable embodiments share the essential features and advantages described above in the contexts of the photovoltaic cell and the manufacturing method according to the present invention.

### DETAILED DESCRIPTION OF THE PRESENT INVENTION

The present invention is described in more detail in the following by means of the accompanying figures where
- figure 1 shows a typical prior art CdTe photovoltaic cell structure,
- figure 2 shows schematically one CdTe photovoltaic cell structure according to the present invention,
- figure 3 shows a comparison of the relative quantum efficiencies between a prior art device and a CdTe photovoltaic cell according to the present invention, and
- figure 4 shows as a flow chart one possible manufacturing method for producing a window layer of a CdTe photovoltaic cell according to the present invention.

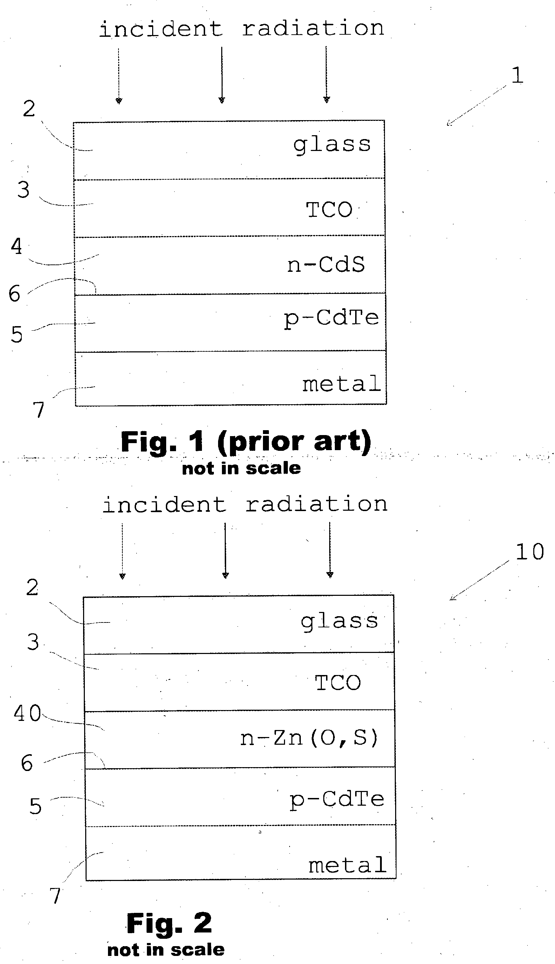

The prior art CdTe/CdS photovoltaic cell 1 of figure 1 is formed on a glass substrate 2 which in the figure is the uppermost layer of the device. A transparent conductive oxide TCO layer 3, comprising e.g. fluorine doped tin oxide FTO deposited on the substrate, forms a transparent current collecting layer. Below the TCO layer is an n-doped CdS window layer 4. Adjacent to this is a p-doped CdTe absorption layer 5 where the actual absorption of the incident photons takes place. The window and absorption layers with different conductivity types form a pn-junction 6 at the interface between them. As the lowermost layer in the device of Figure 1 is a metallic back electrode layer 7 formed of e.g. Cu/Au or Ni/Al.

As well known for the persons skilled in the art, the operation principle of the device is as follows. The incident radiation meets the device on the side of the glass substrate 2. Most of the radiation, excluding the losses due to reflection at the interfaces and possible small absorption losses within the layers, penetrates through the glass and the TCO layers 2, 3 to the n-type window layer 4. The photons which have a lower energy than the bandgap energy of the window layer material propagate further to the absorption layer where they are absorbed, thereby generating free electron-hole pairs. These generated charge carriers are then collected by means of an electrical circuit (not shown) connected to the TCO and the back electrode layers 3, 7.

In figure 2 showing a CdTe photovoltaic cell 10 according to the present invention, most of the parts of the cell are similar with those of figure 1 and they are cited with the same numbers as the corresponding parts in the prior art device of figure 1. As the key difference, the window layer 40 is formed of n-doped Zn(O,S) deposited by ALD. The window layer thickness is between 20 and 50 nm.

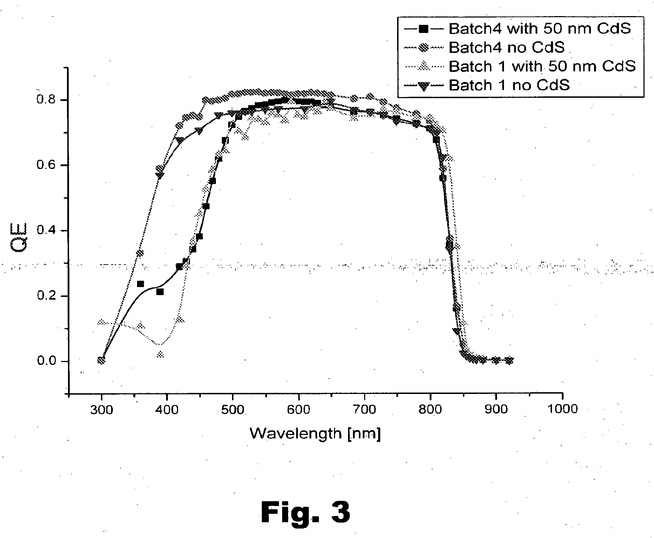

Figure 3 shows measured results for four CdTe photovoltaic cells. Two of the cells represent the basic prior art structure illustrated in Figure 1 with a CdS window layer thickness of 50 nm. Two other cells differ from the prior art cells in that the CdS window layer is replaced with a 50 nm thick layer of Zn(O,S) deposited by ALD. The ALD Zn(O,S) has an O/S cycle ratio of 10/1.

The graphs of figure 3 show a clear improvement in the relative quantum efficiency below 500 nm in the components in which CdS has been replaced with Zn(O,S). In the tested components, the improvement in the quantum efficiency means, in the case of sunlight as the incident radiation, an increase of about 2 - 3 mA/cm², i.e. 10% in the generated current. This means an increment of 1 percentage unit in the total efficiency of the device.

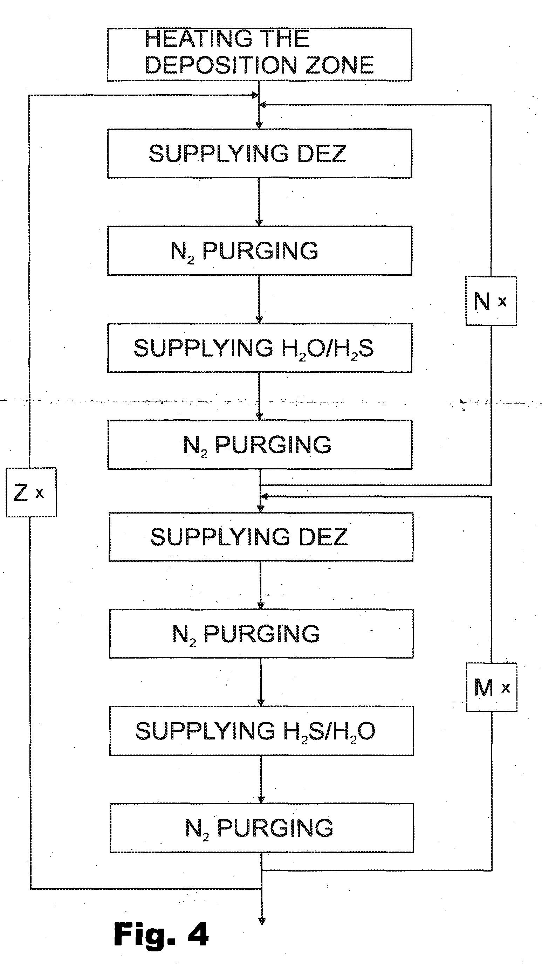

In the ALD process illustrated in figure 4, the deposition zone of the ALD chamber is first heated to the selected deposition temperature, e.g. 200°C. As in a typical ALD process, nitrogen N₂ is used as a carrier and purging gas. The actual ALD process starts by supplying into the deposition chamber, together with an N₂ carrier gas flow, a pulse of diethylzinc DEZ as a precursor for zinc. The nitrogen is supplied into the chamber as a continuous flow. This means that after switching off the supply of DEZ, the chamber is purged, i.e. the excess of the precursor vapor as well as the possible byproducts are removed from the chamber by the continued nitrogen flow. Next, a pulse of water H₂O as a precursor for oxygen or H₂S as a precursor for sulphur, depending on which material of the layered ZnO/ZnS structure is to be deposited first, is introduced into the deposition chamber together with the nitrogen flow. After this, the chamber is again purged by nitrogen.

The durations of the precursor supply and the purging steps depend on the actual ALD reactor used. As an example, durations of 200/400/200/400 ms have been successfully used in Zn(O,S) deposition performed by a Beneq TFS 500 reactor.

The four steps described above form one single ALD process cycle producing one single monolayer of Zn(O,S). The process cycles are repeated sequentially until the desired number N of monolayers of the first material is reached, after which the nonmetallic precursor is changed to the other alternative. In other words, if the first deposited material was ZnO with H₂O as the precursor of the third step of the process cycle, in the next round(s) this precursor is changed to H₂S to produce ZnS, and vice versa. After reaching the desired number M of monolayers of the second material, the process starts again from the beginning with the original precursors. Thus, the deposited material consists of alternating sublayers of ZnO and ZnS, each of which consisting of one or more monolayers. In one preferred embodiment, the thickness of the ZnO sublayer is ten monolayers and that of the ZnS sublayer 1 or 2 monolayers. Depositions of the stacked sublayers are repeated Z times until the desired total thickness of Zn(O,S), e.g. 50 nm, is achieved.

The method illustrated in figure 4 concerns the Zn(O,S) window layer deposition only. Other steps of forming an entire CdTe/Zn(O,S) photovoltaic cell are not in the core of the present invention; they can be carried out according to the principles and processes known in the field.

As is clear for a person skilled in the art, the embodiments of the present invention are not limited to the examples above but they may freely vary within the scope of the claims, taking into account also the possible new potentials opened by the advancement of the technology.

## Claims

1. A thin film photovoltaic cell (10) comprising an n-type semiconductor window layer (40), a p-type semiconductor absorption layer (5), and a pn-junction (6) at the interface between these two layers, wherein the p-type semiconductor absorption layer is formed of cadmium telluride CdTe,
**characterized in that**
the n-type semiconductor window layer (40) comprises zinc oxide/sulfide Zn(O,S) comprising stacked thin layer packages, each of which including one sublayer of ZnO and another of ZnS, the thickness of each ZnO sublayer being 1 - 20 monolayers, and the thickness of each ZnS sublayer being 1 - 10 monolayers.

2. A thin film photovoltaic cell (10) according to claim 1, **characterized in that** said n-type semiconductor window layer material is deposited by atom-ic layer deposition ALD.

3. A method for manufacturing a thin film photovoltaic cell (40) comprising the steps of forming an n-type semiconductor window layer (40) and a p-type semiconductor absorption layer (5) so as to form a pn-junction (6) at the interface between these two layers, wherein the p-type semiconductor absorption layer is formed of cadmium telluride CdTe,
**characterized in that**
the n-type semiconductor window layer (40) is formed so as to comprise zinc oxide/sulfide Zn(O,S) comprising stacked thin layer packages, each of which including one sublayer of ZnO and another of ZnS, the thickness of each ZnO sublayer being 1 - 20 monolayers, and the thickness of each ZnS sublayer being 1 - 10 monolayers.

4. A method according to claim 3, **characterized in that** the n-type semiconductor window layer material is deposited by atomic layer deposition ALD.

5. Use of zinc oxide/sulfide Zn(O,S) in the window layer (40) of a thin film photovoltaic cell (10) comprising an n-type semiconductor window layer (40), a p-type semiconductor absorption layer (5), and a pn-junction (6) at the interface of these two layers, wherein the p-type semiconductor absorption layer is formed of cadmium telluride CdTe, and
wherein
Zn (O,S) comprises stacked thin layer packages, each of which includes one sublayer of ZnO and another of ZnS, the thickness of each ZnO sublayer being 1 - 20 monolayers, and the thickness of each ZnS sublayer being 1 - 10 monolayers .

6. Use according to claim 5, wherein said n-type semiconductor window layer material is deposited by atomic layer deposition ALD.

## Patentansprüche

1. Dünnschicht-Photovoltaikzelle (10) enthaltend eine n-Typ Halbleiter-Fensterschicht (40), eine p-Typ Halbleiter-Absorptionsschicht (5), und einen pn-Übergang (6) an der Schnittstelle zwischen diesen beiden Schichten, wobei die p-Typ Halbleiter-Absorptionsschicht aus Cadmiumtellurid CdTe gebildet ist,
**dadurch gekennzeichnet, dass**
die n-Typ Halbleiter-Fensterschicht (40) Zinkoxid/Zinksulfid Zn(O,S) enthält, das gestapelte Dünnschichtpackungen aufweist, wobei jede davon eine Unterschicht aus ZnO und eine andere aus ZnS enthält, wobei die Dicke von jeder ZnO-Unterschicht 1 - 20 Monoschichten ist, und die Dicke von jeder ZnS-Unterschicht 1 - 10 Monoschichten ist.

2. Dünnschicht-Photovoltaikzelle (10) gemäß Anspruch 1, **dadurch gekennzeichnet, dass** das besagte Material der n-Typ Halbleiter-Fensterschicht durch Atomlagenabscheidung ALD abgeschieden ist.

3. Verfahren zur Herstellung einer Dünnschicht-Photovoltaikzelle (40) umfassend die Schritte der Ausbildung einer n-Typ Halbleiter-Fensterschicht (40) und einer p-Typ Halbleiter-Absorptionsschicht (5), sodass ein pn-Übergang (6) an der Schnittstelle zwischen diesen beiden Schichten gebildet wird, wobei die p-Typ Halbleiter-Absorptionsschicht aus Cadmiumtellurid CdTe gebildet wird,
**dadurch gekennzeichnet, dass**
die n-Typ Halbleiter-Fensterschicht (40) so gebildet wird, dass sie Zinkoxid/Zinksulfid Zn(O,S) enthält, das das gestapelte Dünnschichtpackungen aufweist, wobei jede davon eine Unterschicht aus ZnO und eine andere aus ZnS enthält, wobei die Dicke von jeder ZnO-Unterschicht 1- 20 Monoschichten ist, und die Dicke von jeder ZnS-Unterschicht 1-10 Monoschichten ist.

4. Verfahren gemäß Anspruch 3, **dadurch gekennzeichnet, dass** das Material der n-Typ Halbleiter-Fensterschicht durch Atomlagenabscheidung ALD abgeschieden wird.

5. Verwendung von Zinkoxid/Zinksulfid Zn(O,S) in der Fensterschicht (40) einer Dünnschicht-Photovoltaikzelle (10), die eine n-Typ Halbleiter-Fensterschicht (40), eine p-Typ Halbleiter Absorptionsschicht (5) und einen pn-Übergang (6) an der Schnittstelle dieser beiden Schichten enthält, wobei die p-Typ Halbleiter-Absorptionsschicht aus Cadmiumtellurid CdTe gebildet ist, und
wobei
Zn(O,S) gestapelte Dünnschichtpackungen aufweist, wobei jede davon eine Unterschicht aus ZnO und eine andere aus ZnS enthält, wobei die Dicke von jeder ZnO-Unterschicht 1 - 20 Monoschichten ist, und die Dicke von jeder ZnS-Unterschicht 1 - 10 Monoschichten ist.

6. Verwendung gemäß Anspruch 5, wobei besagtes Material der n-Typ Halbleiter-Fensterschicht durch Atomlagenabscheidung ALD abgeschieden wird.

## Revendications

1. Cellule photovoltaïque à couches minces (10) comprenant une couche fenêtre à semi-conducteur de type n (40), une couche d'absorption à semi-conducteur de type p (5) et une jonction pn (6) à l'interface entre ces deux couches, dans laquelle la couche d'absorption à semi-conducteur de type p est formée de tellurure de cadmium CdTe,
**caractérisée en ce que**
la couche fenêtre à semi-conducteur de type n (40) comprend de l'oxyde/sulfure de zinc Zn(O,S) comprenant des paquets de couches minces empilées, dont chacun inclut une sous-couche de ZnO et une autre de ZnS, l'épaisseur de chaque sous-couche de ZnO étant de 1 à 20 monocouches et l'épaisseur de chaque sous-couche de ZnS étant de 1 à 10 monocouches.

2. Cellule photovoltaïque à couches minces (10) selon la revendication 1, **caractérisée en ce que** le matériau de ladite couche fenêtre à semi-conducteur de type n est déposé par dépôt en couches atomiques ALD.

3. Procédé de fabrication d'une cellule photovoltaïque à couches minces (40) comprenant les étapes de formation d'une couche fenêtre à semi-conducteur de type n (40) et d'une couche d'absorption à semi-conducteur de type p (5) de manière à former une jonction pn (6) à l'interface entre ces deux couches, dans lequel la couche d'absorption à semi-conducteur de type p est formée de tellurure de cadmium (CdTe),
**caractérisé en ce que**
la couche fenêtre à semi-conducteur de type n (40) est formée de manière à comprendre de l'oxyde/sulfure de zinc Zn(O,S) comprenant des paquets de couches minces empilées, dont chacun inclut une sous-couche de ZnO et une autre de ZnS, l'épaisseur de chaque sous-couche de ZnO étant de 1 à 20 monocouches et l'épaisseur de chaque sous-couche de ZnS étant de 1 à 10 monocouches.

4. Procédé selon la revendication 3, **caractérisé en ce que** le matériau de ladite couche fenêtre à semi-conducteur de type n est déposé par dépôt en couches atomiques ALD.

5. Utilisation d'oxyde/sulfure de zinc Zn(O,S) dans la couche fenêtre (40) d'une cellule photovoltaïque à couches minces (10) comprenant une couche fenêtre à semi-conducteur de type n (40), une couche d'absorption à semi-conducteur de type p (5) et une jonction pn (6) à l'interface entre ces deux couches, dans laquelle la couche d'absorption à semi-conducteur de type p est formée de tellurure de cadmium CdTe, et dans laquelle
le Zn(O,S) comprend des paquets de couches minces empilées, dont chacun inclut une sous-couche de ZnO et une autre de ZnS, l'épaisseur de chaque sous-couche de ZnO étant de 1 à 20 monocouches et l'épaisseur de chaque sous-couche de ZnS étant de 1 à 10 monocouches.

6. Utilisation selon la revendication 5, dans laquelle le matériau de ladite couche fenêtre à semi-conducteur de type n est déposé par dépôt en couches atomiques ALD.
